# EUROPEAN PATENT SPECIFICATION

(11) **EP 3 271 161 B1**
(45) Date of publication and mention of the grant of the patent: **17.11.2021**
(21) Application number: 16707423.6
(22) Date of filing: 01.03.2016
(51) Int. Cl.: B29C 70/70, B29C 70/72, B29C 67/00, H05K 1/18, H05K 3/12, B33Y 30/00, B33Y 10/00, B33Y 80/00

(54) **METHOD FOR THE PRODUCTION OF A 3D PRINTED OBJECT AND 3D PRINTER APPARATUS**
VERFAHREN ZUR HERSTELLUNG EINES 3D-DRUCKOBJEKTS UND 3D-DRUCKVORRICHTUNG
MÉTHODE POUR LA PRODUCTION D'UN OBJET IMPRIMÉ EN 3D ET APPAREIL D'IMPRESSION EN 3D

(30) Priority: 17.03.2015 EP 15159352
(43) Date of publication of application: 24.01.2018
(73) Proprietor: Signify Holding B.V., 5656 AE Eindhoven (NL)
(72) Inventor: TALGORN, Elise, Claude, Valentine, 5656AE Eindhoven (NL); LIBON, Sébastien, Paul, René, 5656AE Eindhoven (NL); VAN DEN ENDE, Daan, Anton, 5656AE Eindhoven (NL); JACOBS, Egbertus, Reinier, 5656AE Eindhoven (NL); BEAUMONT, Dave, 5656AE Eindhoven (NL); CHERENACK, Kunigunde, Hadelinde, 5656AE Eindhoven (NL); HIKMET, Rifat, Ata, Mustafa, 5656AE Eindhoven (NL)
(74) Representative: Verweij, Petronella Daniëlle
(86) International application number: PCT/EP2016/054282
(87) International publication number: WO 2016/146374

(56) References cited:
- WO-A2-2012/143923
- US-A1- 2004 145 629
- US-A1- 2009 177 309
- US-A1- 2013 170 171

## Description

### FIELD OF THE INVENTION

The invention relates to a method for the production of a 3D printed object, especially including a functional component. The invention further relates to a 3D printer, which may for instance be used in such method for the production of a 3D printed object, especially including a functional component.

### BACKGROUND OF THE INVENTION

Additive technologies wherein a material is incorporated in an object made via such technology are known in the art. US2013303002, for instance, describes a three-dimensional interconnect structure for micro-electronic devices and a method for producing such an interconnect structure. The method comprises a step wherein a backbone structure is manufactured using an additive layer-wise manufacturing process. The backbone structure comprises a three-dimensional cladding skeleton and a support structure. The cladding skeleton comprises layered freeform skeleton parts that will form the electric interconnections between the electric contacts of the interconnect structure after a conductive material is applied on the backbone structure. The support structure supports the layered freeform skeleton parts. Parts of the support structure may be removed to isolate and/or expose the electric interconnections. The cladding skeleton can be embedded by an insulating material for providing a further support. Amongst others, the cladding skeleton parts form a single connected tube that is cladded on an inside surface by flushing a plating fluid trough the tube for forming the electric

US 2013/170171 A1, WO 2012/143923 A2 and US 2004/145629 A1 disclose different 3D printing methods and apparatuses.

Additive manufacturing (AM) is a growing field of materials processing. It can be used for rapid prototyping, customization, late stage configuration, or making small series in production. In many cases to create new functionalities in 3D printed objects a conducting wire or path ("track") is necessary for electrical power. For example when encapsulating an LED one may require conducting wires in order to drive and switch it. Fitting wires in 3D-printed parts requires complex printing geometries and limits the printing freedom. In addition, applying wires during the printing severely hinders the printing process and speed (e.g. the printing has to be paused to inserts wires). Also the threading connections may remain a weak point. Printing pure metal conductive paths in a part is not possible with the current 3D-printing technologies. Further, techniques that allow printing metal (laser or e-beam induced metal particle sintering/melting) do not allow the concomitant printing of another material. Techniques that allow multi-material printing like Fused Deposition Modelling (FDM) or jetting, etc., do not yet allow the printing of electrically conductive metals. To overcome this problem metal based printing composites filaments can be used, which show relatively good conductive properties. These filaments, though, will have to be alternated with insulating filaments to create a 3D conducting channel.

When considering making 3D electronic circuits, there are different possible ways to add the components and/or electrical circuits: all components (or electronic circuits) are placed on the build platform and the 3DP (3D printed or 3D printing) part is printed around and on top of them; multiple parts are added on various layers through-out the 3DP process. Components can be distributed throughout the part; the 3D part is first printed, then components are attached to the surface; and a part is printed and components are pulled/injected in the part (e.g. flex strips or other daisy chains). Of course, the various electronic parts have to be connected in order to form a circuit. For some of these options this seems (relatively) straightforward and connections can be achieved with conventional wiring methods. There are also various strategies that have been attempted to add interconnects to such 3D printed object. For instance, strategies may include adding interconnects on the surface of 3D shapes, such as overprinting a 3D shape with conducting tracks using e.g. jetting technologies or printing conducting tracks using e.g. a multi material FDM process with multiple nozzles. Similar 3D shapes with interconnects and circuits on their surface can be achieved by more conventional mass-manufacturing processes e.g. molded interconnect devices (MID) technologies. It might also be possible to add components inside the 3DP part. For instance, layers may be built up by depositing a film of powder and using a laser to melt areas where the sold parts should be formed. For instance, one may use a process including depositing a film of powder, using a modified vacuum tool to suck out cavities of powder, dropping a component into the cavity, and then continuing with the print process.

3DP prototypes with embedded electronics may (thus) have interconnects (i.e. electrical interconnects) and components on the outside of the part. This exposes components to mechanical damage and can make circuits more fragile and prone to damage. It does also leave tracks and component pads exposed, resulting in potential health risks for user (e.g. electrocution) and reliability risks for the product (e.g. moisture induced short circuits and corrosion). One technology that might be able to connect parts vertically is the multi-nozzle FDM process mentioned above if one nozzle is used to print a conducting material. The disadvantage of this approach is that FDM compatible conducting materials are not widely available and are in general also not highly electrically and thermally conductive (certainly compared to metal wires). This means that 3D printed conductive tracks that are used to connect components will have relatively large resistances and cannot be used to conduct large currents. Using these materials in circuits will result in large losses, thermal heating and low efficiencies.

### SUMMARY OF THE INVENTION

Hence, it is an aspect of the invention to provide an alternative method for printing a 3D object, which preferably further at least partly obviates one or more of above-described drawbacks. It is also an aspect of the invention to provide an alternative 3D printer, for instance for use in such method for printing a 3D object, which (alternative 3D printer) preferably further at least partly obviates one or more of above-described drawbacks.

Here we propose a simple way to add conducting (or insulating) tracks to the inside of 3DP parts, essentially once the print process (or a part thereof) is finished. Functional components, such as electrical components (e.g. a surface mount device (SMD), an organic light emitting device (OLED), a (small) printed circuit board (PCB), a sensor, a thin film transistor (TFT) circuit (e.g. its printed on a flexible foil), can be embedded into various layers during the print process e.g. by using a pick and place tool, or by inserting flexible circuits using a roll-to-roll process. The table below shows some of the 3DP processes that could be used and the insertion method that may be most suitable. Finally, conducting tracks can be added by injecting liquid (conducting or insulating) into hollow tunnels fabricated inside the 3DP part (this could alternatively or additionally also be done by dipping the component in a liquid bath). The liquid may e.g. be cured inside the tunnel, or the tunnel is sealed to keep the liquid inside.

| **3DP Process** | **Material of the 3DP part** | **Insertion method:** |
|---|---|---|
| Fused deposition modelling (multi nozzle) | Polymer (non-conducting) | Pick and place (PCB, SMD components OLED...) |
| Laminated Object Manufacturing (LOM) | Paper / foil (non-conducting | Roll to roll 2D foil (printed interconnects and attached devices, thin film circuits and OLEDs on foil...) |
| Ultrasonic additive manufacturing (UAM) | Metal | Roll to roll 2D foil (printed interconnects and attached devices, thin film circuits and OLEDs on foil...) |
| Material jetting (MJM, polyjet) | Polymer (non-conducting) | Pick and place (PCB, SMD components OLED...) |
| Vat polymerization stereo lithography (SLA), direct light processing (DLP) | Polymer (non-conducting) | Pick and place (PCB, SMD components OLED...) |
| Powderbed fusion selective laser melting (SLM), selective laser sintering (SLS), direct metal laser sintering ( DMLS), electron beam melting (EBM) | Ceramic and polymer (non-conducting), metal (conducting) | Pick and place (PCB, SMD components OLED...) |

Hence, in a first aspect the invention provides a method for the production of a 3D printed object ("object" or "3D object"), wherein the method comprises (i) a 3D printing stage, the 3D printing stage comprising 3D printing a 3D printable material to provide the 3D printed object (from at least said printable material), wherein the 3D printing stage further comprises forming during 3D printing a tunnel (i.e. in fact printing a 3D tunnel) in the 3D printed object (under construction), wherein the method further comprises (ii) after the 3D printed object has been completely printed, a filling stage comprising filling the tunnel with a flowable material, wherein the flowable material comprises a functional material, wherein the functional material has a higher electrical conductivity than the 3D printed object, and/or has a higher thermal conductivity than the 3D printed object, and/or has radiation transmissive properties, and/or comprises a magnetic material, and wherein the filling stage comprises immobilizing said functional material. Herein, the term "radiation transmissive properties" especially refers to material transmissive for UV radiation, visible radiation and IR radiation, herein further also indicated as "light transmissive properties".

As indicated above, the 3D printing stage comprises the step of forming, during 3D printing, a tunnel in the 3D printed object under construction. Hereinafter, the term "channel" is used to also refer to the aforementioned tunnel.

With such method for instance electrically (highly) conductive tracks may be produced. Further, with such method it is possible to provide 3D printed objects with the functional component entirely embedded in the 3D printed object (though partly embedded may also be an option). Further, robust electrically conductive tracks may be provided with a relatively easy method. For instance, using prior art solutions, such as including electroplating, it may be that the flowable material leaks away and/or the electrical tracks are relatively weak. Further, electrically conductive tracks provided by the present invention may be much more electrically conductive than provided e.g. with alternative options, such as some using particular electrically conductive polymers. Further, with the present invention it is now possible placing (e.g. electrically) interconnecting structures with a higher precision at 'exactly' the right place inside the 3D structure. For instance, when applying external tracks, this may be much more complicated and vulnerable to damage.

The terms "3D printed object" or "3D object" refer to a three dimensional object obtained via 3D printing (which is an additive manufacturing process), such as an object having a height, a width and a length. The 3D (or 3DP) object can in principle be any object that is 3D printable. It can be an item with a use function or a purely decorative item. It can be a scale model of an item such as a car, a house, a building, etc. Further, the 3D object can be a piece or element for use in another device or apparatus, such as a lens, a mirror, a reflector, a window, a collimator, a waveguide, a color converting element (i.e. comprising a luminescent material), a cooling element, a locking element, an electrically conducting element, a casing, a mechanical support element, a sensing element, etc.. The 3D printed object comprises 3D printed material.

Additive Manufacturing (AM) is a group of processes making three-dimensional objects from a 3D model or other electronic data source primarily through additive processes. Hence, the term "3D printing" is substantially equivalent to "additive manufacturing" or "additive manufacturing method". The additive process can involve the binding of grains (via sintering, melting, or gluing) or of layers of material (via successive deposition or production of the layers, e.g. polymerization), etc. A widely used additive manufacturing technology is the process known as Fused Deposition Modeling (FDM). Fused deposition modeling (FDM) is an additive manufacturing technology commonly used for modeling, prototyping, and production applications. FDM works on an "additive" principle by laying down material in layers; a plastic filament or metal wire is unwound from a coil and supplies material to produce a part. Possibly, (for thermoplastics for example) the filament is melted and extruded before being laid down. FDM is a rapid prototyping technology. Another term for FDM is "fused filament fabrication" (FFF). Herein, the term "filament 3D printing" (FDP) is applied, which is considered to be equivalent to FDM or FFF. In general, FDM printers use a thermoplastic filament, which is heated to its melting point and then extruded, layer by layer, (or in fact filament after filament) to create a three dimensional object. FDM printers can be used for printing a complicated object. Hence, in an embodiment the method includes production of the 3D printed object via an FDM 3D printing.

The 3D printed object is especially (at least partly) made from 3D printable material (i.e. material that may be used for 3D printing).

In general these (polymeric) materials have a glass transition temperature T_{g} and/or a melting temperature Tₘ. The 3D printable material will be heated by the 3D printer before it leaves the nozzle (assuming e.g. FDM) to a temperature of at least the glass transition temperature, and in general at least the melting temperature. Hence, in an embodiment the 3D printable material comprises a thermoplastic polymer, such as having a glass transition temperature (T_{g}) and /or a melting point (Tₘ), and the printer head action comprises heating the one or more of the receiver item and 3D printable material deposited on the receiver item to a temperature of at least the glass transition temperature, especially to a temperature of at least the melting point. In yet another embodiment, the 3D printable material comprises a (thermoplastic) polymer having a melting point (Tₘ), and the printer head action comprises heating the one or more of the receiver item and 3D printable material deposited on the receiver item to a temperature of at least the melting point. Specific examples of materials that can be used (herein) can e.g. be selected from the group consisting of acrylonitrile butadiene styrene (ABS), polylactic acid (PLA), polycarbonate (PC), polyamide (PA), polystyrene (PS), lignin, rubber, etc.

As indicated above, also techniques other than FDM may be applied, such as inkjet printing, stereo-lithography, spray printing, powder bed printing, etc. As indicated above, whatever printable material is used, it will especially include an electrically conducting species or a precursor thereof. The term "printable material" may also refer to a plurality of different 3D printable materials. The term "printable material" especially refers to material that can be printed. For instance, in the case of FDM the printable material may comprise a heated polymer that is flowable. The printable material may be solid at room temperature, but upon heating may become printable (i.e. especially flowable). This heating is especially intended to provide a flowable or printable material. In the case of stereo-lithography, the printable material may comprise liquid material that is curable (by light, such as laser radiation), etc. In the case of inkjet printing, the printable material may comprise particles in a liquid (that may (be) evaporate(d) after deposition). In the case of powder binding the printable material may comprise particles that are held together by a binding material (glue). In the case of powder sintering or melting the printable material may comprise particles that are sintered or melted together by applying heat.

As indicated above, the method includes a 3D printing stage, the 3D printing stage comprising 3D printing a 3D printable material to provide the 3D printed object (i.e. manufacturing the 3D printed object), from at least said printable material. The term "printed material" especially herein refers to printable material that has been deposited or printed. Hence, the term "printable material" herein especially refers to the material not (yet) deposited or printed. The printing stage may, amongst others, also include a curing. For instance, printed material may be cured after printing, followed by further printing on the cured printed material.

Further, the printing stage may also include providing a functional component, before the 3D printing of the printable material, during the printing of the printable material and after the printing of the printable material. As the printing of the printable material is especially a step by step process (layer by layer formation), e.g. during the printing a functional component may added to the 3D printed object under construction, followed by further printing of printable material. The term "under construction" especially indicates the time frame between (t=0) printing of a first part of the 3D printing object until the printing of a last part of the 3D printed object. Especially, the product obtained between t=0 and the last printing action is herein also indicated as 3D object. However, sometimes this object when it is being made is also indicated as "3D object under construction", or similar terms. For instance, this nomenclature can be used to stress that a certain action is executed during the 3D printing process.

The printing stage further comprises forming during 3D printing a channel in the 3D printed object (under construction). This implies that deliberately a channel is formed in the 3D printed object by keeping a part, i.e. a channel, free from printed material. The channels are provided during 3D printing. The 3D printing leads to a 3D object. Therefore, the 3D printing stage (further) comprises forming during 3D printing a channel in the 3D printed object under construction. Hence, in fact the channel is printed, i.e. the 3D object is printed in such a way that a channel is formed during 3D printing. While 3D printing, a part is left functionally free from 3D printable material (thereby forming a channel).

Of course, the 3D object may include a plurality of channels. The term "channel" may also refer to a plurality of channels. For instance, in view of electric applications, channels will in general be provided as set(s) of two channels, to provide an electrical circuit. The channels may have any (functional) length. Further, the cross-section of the channel may be round, square, rectangular, etc. etc. For instance, in embodiments the channel may also have a layer-like shape. In general the equivalent circular diameter (2*sqrt(Area/π:), where sqrt is an abbreviation of the square root) will be in the range of 0.05-100 mm, such as 0.2-50 mm, which may depend upon the size of the 3D object. As indicated above, even when complying with this equivalent circular diameter, the shape of the cross-section may vary over the channel length (but still substantially complying with the indicated range over substantially the entire channel length). Also different types of channels may be applied.

The filling of the channels may be done during printing. For instance, part of a channel is formed, or a channel is ready, and then the channel is filled with flowable material, followed by an optional curing, followed by further 3D printing, which further 3D printing may optionally also further include the generation of channels and filling of the channels with flowable material. In the method according to the invention, first the object is substantially entirely 3D printed, followed by the filling of the channel(s). Hence, the method thus further comprises (ii) a filling stage comprising filling the channel with a flowable material.

The terms "printing stage" and "filling stage" do not necessarily include a complete printing of the 3D printed object followed by filling, but may also include a plurality of such stages sequentially applied. However, in the method according to the invention the 3D object is first completely printed, followed by a filling of the channel with flowable material.

As indicated above, the flowable material comprises a functional material. Hence, the functional material is introduced in the 3D printed object (under construction) as flowable functional material, such as e.g. a low melting solder (see further below). Alternatively or additionally, the functional material is introduced with a flowable carrier, such as a silver comprising (flowable and curable) polymer (see further below). Optionally, before filling with the flowable material, the channel walls of the channels may be functionalized, e.g. with a coating facilitating introduction of the flowable material. For instance, a hydrophobic channel wall may be made more hydrophilic when an aqueous flowable material is applied, etc.. Such functionalization might lead to a (slightly) reduced channel volume and channel equivalent circular diameter.

In general, the total channel volume of the channels (filled with functional material, see below) relative to the total volume of the printed material including the channels filled with functional material may be in the range of 0.05-20 vol.%, such as 0.5-10 vol.%. Further, in general the channel(s) will be filled with functional material in the range of at least 70 vol.%, such as at least 80 vol.%, even more especially at least 90 vol.% of the channel volume, such as substantially entirely filled with functional material. Hence, in an embodiment the channel is filled for at least 90 vol.% with the functional material.

The channels may be filled with a liquid (flowable material), for instance by injecting a flowable liquid, such as with a syringe. However, the 3D printed object may e.g. also be dipped (submerged) in the flowable material.

Especially, the flowable material has a viscosity larger than water, such as equal to or larger than 2 mPa.s at 20 °C, such as equal to or larger than 5 mPa.s, like equal to or larger than 10 mPa.s, such as equal to or larger than 50 mPa.s, especially equal to or larger than 100 mPa.s, like equal to or larger than 0.5 Pa.s at 20 °C. Especially however, the viscosity of the flowable material at 20 °C is equal to or smaller than 100 mPa.s, such as equal to or smaller than 50 mPa.s. Using flowable material having a relative high viscosity, larger than water, such at least a viscosity twice as large, appears to be beneficial, especially in view of powder printed or filament printed 3D objects. Here, the viscosities are indicated prior to immobilizing the functional material. Additionally or alternatively, a vacuum may assist the filling. Hence, in a further embodiment the filling stage comprises subjecting the 3D printed object to a sub-atmospheric pressure and subsequently filling the channel with the flowable material. Alternatively or additionally, an aperture connected to the channels to be filled in the 3D printed object (under construction) can be used as a vacuum inlet. Hence, it may in embodiments be necessary to provide the flowable material at elevated temperatures, in view of flowability. This is known in the art. Hence, the term flowable may also refer to flowable or liquid at the application temperature, such as flowable or liquid when heated to a temperature in the range of 50-150 °C. The phrase "filling the channel" especially implies the use of a flowable or liquid material (at the application temperature of the flowable or liquid material, i.e. when filling with the flowable or liquid material). The term "flowable material" may also refer to a plurality of flowable or liquid materials. They may be introduced in a channel at the same time, or sequentially.

Further, the use of bifurcations, may assist in filling the channel with flowable material. With a bifurcation structure, the channel may split ("pure bifurcation") in two or three ("crossing") or more channels. Hence, in an embodiment the channel comprises a bifurcation structure. Especially, the bifurcation provides two or more outlets (or inlets).

After having filled the channel, the functional material is immobilized. In an embodiment the functional material is immobilized by one or more of (a) closing said channel and (b) curing said functional material comprising flowable material. In the former embodiment, the flowable material may keep its flowable properties, though flowing is substantially inhibited by the closure of the channel. Hence, especially in such embodiments the channel filled with flowable material is at least 90 vol. %, even more especially at least 95 vol.%, such as especially at least 98 vol.%. This may also apply for the latter embodiment, though by the curing, the flowable material is converted in a material that may not be able to flow anymore. However, also in this embodiment the channel may be filled with flowable material for at least 90 vol. %, even more especially at least 95 vol.%, such as especially at least 98 vol.%. Further, also in this embodiment the channel may be closed after filling, e.g. for esthetical and/or safety reasons. Hence, immobilization may amongst others be achieved by (substantially entirely) filling the channel, such as at least 90 vol. %, and closing the channel. Alternatively or additionally, immobilization may amongst others be achieved by filling the channel with flowable material and curing the flowable material. Hence, the flowable material may comprise curable material. Optionally, the functional material comprises curable groups, but alternatively or additionally, the flowable material comprises (in addition to the functional material) a curable material.

The flowable material may especially also have a low shrinkage (upon curing) (typically smaller than several volume%) and the coefficient of thermal expansion should especially be close to the (thermal expansion of the) 3D printed material in the range of possible operating temperatures of the printed device to reduce processing-induced residual stresses. Hence, especially a ratio of the thermal expansion of the printed material and of the (cured) flowable material may especially be in the range of 0.6-1.4, like 0.7-1.3, such as 0.8-1.2, like 0.9-1.1.

As indicated above, the flowable material may in an embodiment comprise a curable material. Curing may for instance be executed by one or more of light and heat, as known in the art. Would the 3D object include a radiation transmissive material, such as a material transmissive for one or more of UV, visible and IR radiation, also curing by light/radiation may be applied. Alternatively or additionally, heat may be applied. Hence, especially the curable material is a thermally curable material. Therefore, in an embodiment the curable material comprises a thermally curable material, and the method further comprises subjecting at least part of the 3D printed object to heat (to cure the curable material). Hence, the 3D object, when under construction and/or when finished, may be cured, e.g. by heat. Therefore, in an embodiment of the method the flowable material comprises a curable material, and the method further comprises curing said flowable material to provide cured flowable (functional) material. In a further specific embodiment, the flowable material comprises a thermally curable material, and the method further comprises subjecting at least part of the 3D printed object (under construction) to heat (to cure the thermally curable material). Alternatively or additionally, in an embodiment of the method the flowable material comprises a polymerizable material, and the method further comprises polymerizing said flowable material to provide polymerized flowable (functional) material. Hence, this may also be an option to immobilize the functional material. Different immobilization methods may be combined.

The flowable material is introduced in the channel to provide the 3D object with a functional material. This functional material may functionally be connected with a functional element (see further below).

Especially, the functional material has one or more of electrically conductive properties, thermally conductive properties, radiation transmissive properties, and magnetic properties. As indicated above, such functional material is immobilized (in the 3D printed object). The term "electrically conductive properties" and similar terms imply that the material is electrically conductive; likewise this applies to the other herein indicated functional properties of the functional material.

In a specific embodiment, the functional material comprises electrically conductive properties and the channel is used as electrically conductive track or wire. Hence, in an embodiment the flowable material comprises a metal particles comprising polymer, such as a silver particles comprising polymer. Such polymers are e.g. described in WO2013191760, which is herein incorporated by reference. Therefore, in an embodiment the flowable material comprises a silver-containing polymer composite having stability against coagulation of silver comprising silver-loaded silicone particles, especially having a loading content of silver in the range of from about 0.1 to about 70 wt.% of the total amount of the silver-loaded silicone particles, wherein the silver-loaded silicone particles are loaded in a formulation of polymers comprising one or more polymers, polymer blends, or polymer composites especially in the range of from about 0.01 to about 50 wt.% of the formulation of polymers. More especially, the silver-loaded silicone particles have a loading content of silver in the range of from about 0.1 to about 50 wt.% of the total amount of the silver-loaded silicone particles. Especially, the metal particles comprising polymer, such as a silver particles comprising polymer is curable. In this way, an electrically conductive channel may be provided. In another embodiment, the flowable material comprises a low melting solder melting at a temperature selected from the range of 50-400 °C. For instance, the flowable material may comprise any conducting liquid or molten alloy, such as low temperature Sn based solder alloys like SnBi, SnBiAg, SnBiCu, SnIn, etc. In yet another embodiment, the flowable material comprises a conducting ink (e.g. ICA (isotropically conductive adhesive)) used widely in the printed circuit board industry. It would also be possible to use inexpensive ionic conducting liquids, e.g. tap water to achieve cost-reduction. Hence, the printable material (in such embodiments) or at least the thus obtained printed material will have electrically insulating properties.

When the 3D printed object has been printed substantially (and an optional curing has been performed), a final (3D printing) action may be executed, for instance to provide a closure layer to close an opening of the channel. Hence, in an embodiment the method further comprises (iii) a finishing stage subsequent to the filling stage, wherein the finishing stage comprises closing a channel opening, optionally also by 3D printing. Note that this finishing stage, or more precisely, the closing of the channel, is not always necessary. For instance, one may accept the fact that a cured material is visible at the end of a channel at an outer surface of the 3D object. Note that the finishing stage may optionally also include one or more of (a) heating (such as by a laser and/or a flame) at least part of the outer layer of the 3D object, (b) solvent dissolving at least part of the outer layer of the 3D object, and (c) coating at least part of the outer layer of the 3D object. Alternatively, the finishing stage may be subsequent to the filing, but before a curing. Hence, optionally curing is only done after the 3D printed object is entirely printed. Hence, optionally the filing stage and finishing stage may at least partly overlap.

As indicated above, the inclusion of the functional material is especially executed in view of a functional component associated with the 3D object. This association may be done before the printing (the functional component may be provided on a receiver item on which the 3D printed object is printed), during the printing stage, and after the printing stage. Hence, in an embodiment the printing stage further comprises at least partially incorporating a functional component in the 3D printed object under construction, wherein the filling stage further comprises functionally connecting the functional component with the functional material by filling said channel with said flowable material. Therefore, the channel and the functional component are configured in a functional configuration. For instance, assuming an electrical component, the component may have two connectors extending in two different channels for (a later) powering by an electrical power source. By filling the channels with flowable material, the functional material, in this example especially also electrically conductive material, comes into contact with the two connectors, respectively. Optionally, the method may thus comprise a further processing said flowable material, such as curing. The thus obtained functional material in the channel(s) can be used as electrical wire to power the electrical component. Note that when there is more than one channel, the channels may be filled at the same time or sequentially.

Hence, in an embodiment the functional component comprises one or more of an electrical component, a solenoid, an antenna, a capacitive coupling structure, and an electro magnet. In a specific embodiment, the functional component comprises a light source (as electrical component). Therefore, in embodiments, the functional material especially comprises an electrically conductive material. Other examples of functional components are also mentioned above. Further examples of functional components may e.g. include one or more of an (electrical) connector, a photodetector, a resistor, a switch, a transducer, a semiconductor (like a diode, a transistors, an integrated circuit (IC), an opto electronic component, a display), a sensor, a detector, an RFID chip, an antenna, a resonator, a piezo electronic device, a protection device (such as a surge or a fuse), etc.

Especially thus, the functional components and the functional material are configured in a functional relationship. Hence, the functional components may especially include also one or more electrically conductive properties, thermally conductive properties, radiation transmissive properties, and magnetic properties. A capacitive coupling structure or a capacitor may include two electrically conductive elements separated by an electrically insulating material (or an electrically insulating gas). For instance, such capacitor may be used to electrically charge or power a functional component comprised by the 3D printed object.

The functional component may be partly enclosed by the 3D printed object. Hence, optionally part of the functional component may be visible to a user of the 3D object. However, in another embodiment the functional component is completely incorporated in the 3D printed object. Hence, the functional component may be completely encapsulated by the 3D printed object. Assuming a light transmissive matrix, or at least part of the matrix being light transmissive, also a light source might be completely incorporated in the 3D printed object. The term "functional component" may also relate to a plurality of functional components.

A 3D printed object obtainable by the herein described method comprises (i) a functional component at least partially incorporated in the 3D printed object, the 3D printed object at least comprising (ii) a channel integrated in the 3D printed object, wherein the channel comprises an immobilized functional material, wherein the functional material comprises one or more of electrically conductive properties, thermally conductive properties, radiation transmissive properties (such as transmissive for visible light), and magnetic properties. As indicated above, such 3D printed object especially includes a functional component, which may comprise in embodiments one or more of an electrical component, a solenoid, an antenna, a capacitive coupling structure, and an electro magnet; the functional component and the functional material are functionally coupled.

In an embodiment, the functional material is an electrically conductive material. Especially, the electrical conduction of such functional material is thus higher than of the surrounding 3D printed material, such as at least 1000 times higher. Especially the electrically conductive material has an electrical conductivity of at least 0.01 S/cm, especially at least 0.1 S/cm, such as at least 1 S/cm, like e.g. in the range of 1-1000 S/cm. Especially, the (surrounding) printed material has an electrical conductivity of at maximum 1.10⁻⁵ S/cm, even more especially at maximum 1.10⁻⁶ S/cm. Hence, the terms "electrically nonconductive" or "electrically isolating" especially indicate a conductivity of at maximum 1.10⁻⁵ S/cm; the term "electrically conductive" especially indicates a conductivity of at least 0.01 S/cm. The electrically conductive channels may e.g. be used to provide power to an electrical component, such as a light source. Hence, the functional component may in an embodiment comprise a light source, such as a LED (such as an OLED). Hence, the printable material, or especially the (thus obtained) printed material is electrically insulating in embodiments wherein the functional material is electrically conductive.

The functional material may also be used for thermal management. Hence, the functional material may have thermally conductive properties. Especially, the thermal conductivity of such functional material is thus higher than the thermal conductivity of surrounding 3D printed material, such as at least 5 times higher. Especially, the thermally conductive material has a thermal conductivity of at least 0.5 W/(m.K), such as at least 0.5 W/(m.K). Especially, the (surrounding) printed material has a thermal conductivity of at least 5 times lower, such as at maximum 0.1 W/(m.K). Thermal management may be relevant in 3D printed objects with functional components that heat up. Electrical interfaces like PCB circuits are often combining electrical and thermal functions. Very often, the metallic region close to the component is extended to allow thermal spreading. Also, metal is added under and around the component for more thermal spreading, better thermal transfer to the next thermal interface or even direct heat sinking. All of these aspects require special treatments and added costs. Also because of their typical 2D nature layers will be added to the system increasing real estate around the component. One does not really control their 3D shape. By injecting thermal structures close and around the components, one can make morphological design giving the best 3D compromise of the desired shape with regard to the thermal management needed and also other aspects of integration, like with regard to size/shape of the product. Thermal(ly conductive) channels could also be used to transfer the heat through complex structures from the component to a heat sink, allowing having them far away from each other and even not aligned. Intermediate spreading structures can also allow to couple or decouple components far away or close to each other. An example of this problem can be found in multi-color LED devices. LEDs of different colors generate different amounts of heat and have different temperature sensitivities. One could precisely balance/compensate for these differences and imperfections.

In yet a further embodiment, the functional material may comprise a magnetic material. For instance, the channel structure may also be used to create a solenoid from a channel comprising electrically conductive material and a channel comprising magnetic material. In this way, one may e.g. be able to integrate a transformer in a 3D printed object. For instance, the functional material may include a ferro fluid and/or a ferro paste (both may contain nano ferro or ferrimagnetic particles), a rheonetic material, a metal based magnetic paste (such as comprising one or more of Fe, Co, Ni and CrO₂), a molecule based magnetic paste (works in general only at cryogenic temperatures), and a magnetoresistive material.

In a specific embodiment, the functional material comprises an electrically conductive material, and the functional material comprises one or more selected from the group consisting of (i) a metal particles comprising polymer, such as a silver particles comprising polymer and (ii) a low melting solder melting at a temperature selected from the range of 50-400 °C. In yet another embodiment, the functional material may comprise one or more of graphene and graphite. In such instance, the flowable material may comprise the functional material especially above the percolation limit (i.e. the flowable material is (also) electrically conductive (and so the immobilized flowable material will also be)).

In yet a further embodiment, the functional material comprises radiation transmissive properties, i.e. especially the functional material is transmissive for radiation, especially one or more of UV, VIS and IR radiation, especially one or more of UV (especially 180-380 nm) and VIS (380-780 nm). The term "transmissive" especially indicates herein that when part of the radiation is coupled into the radiation transmissive material, also part of the incoupled light will also couple out again, such as at least 10% at one or more wavelength within the indicated wavelength range(s).

In yet a further embodiment, the functional may comprise mechanical properties, such as providing enhanced friction. In yet another embodiment, the functional material may include acoustic properties, for instance to tune the resonance of the 3D printed object (or part thereof). Yet, the functional material may also have chemical properties, e.g. to offer a channel that could dissolve under certain conditions and/or for release of an active substance.

In a further aspect, the invention provides a 3D printer apparatus for providing a 3D printed object, the 3D printer apparatus comprising (i) a 3D printer configured to provide printable material to completely print the 3D printed object, wherein the 3D printer apparatus further comprises (ii) a functional material providing device (such as a 3D printer) configured to provide flowable material, comprising a functional material, to a tunnel of said completely printed 3D printed object, and (iii) a transportation unit configured to transport a functional component from a storage position to a completely printed 3D printed object for at least partial integration of said functional component in said 3D printed object. With such printer, e.g. the method as herein described may be applied. In a specific embodiment, the printer comprises an FDM printer or a stereo lithography printer or an inkjet printer. Hence, in a further specific embodiment the invention provides a 3D printer for providing a 3D printed object, the 3D printer comprising a printer head comprising a first nozzle for printing a 3D printable material to a receiver item, the 3D printer further comprising a second printer nozzle for providing a flowable material comprising functional material, and wherein the 3D printer further comprises a transportation unit configured to transport a functional component from a storage position to a 3D printed object under construction for at least partial integration of said functional component in said 3D printed object.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figs. 1a-1i schematically depicts some aspects of an embodiment of the herein described method and the 3D printed object;
Figs. 2a-2d very schematically show some stages and aspects of an embodiment of the method and the 3D printed object;
Fig. 3 schematically depict an embodiment of a 3D printer (or AM printer); and
Figs. 4a-4b schematically depict some channel and filling aspects.

The schematic drawings are not necessarily on scale.

### DETAILED DESCRIPTION OF THE EMBODIMENTS

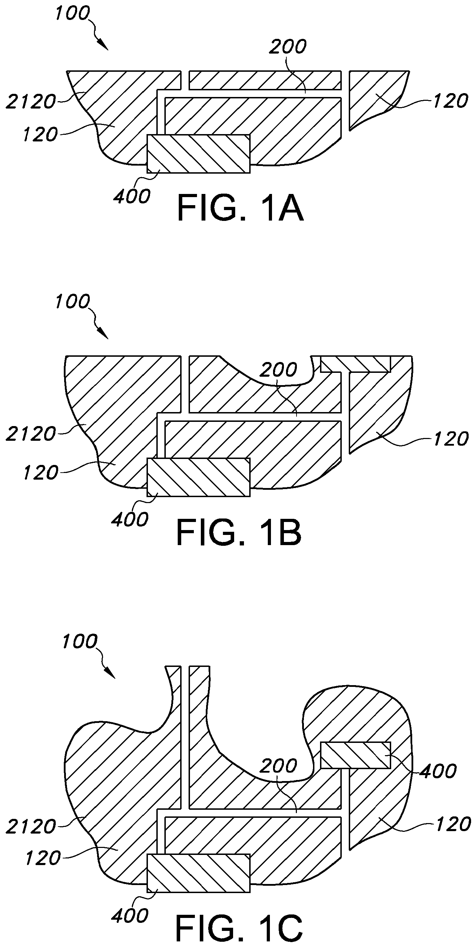

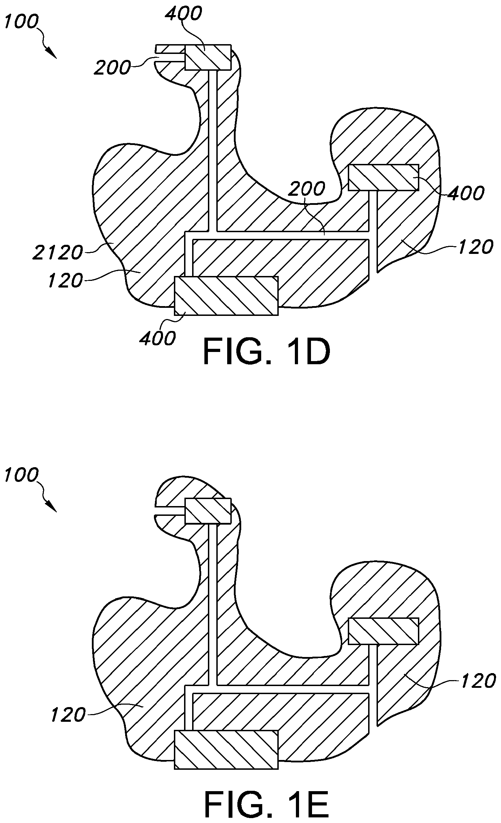

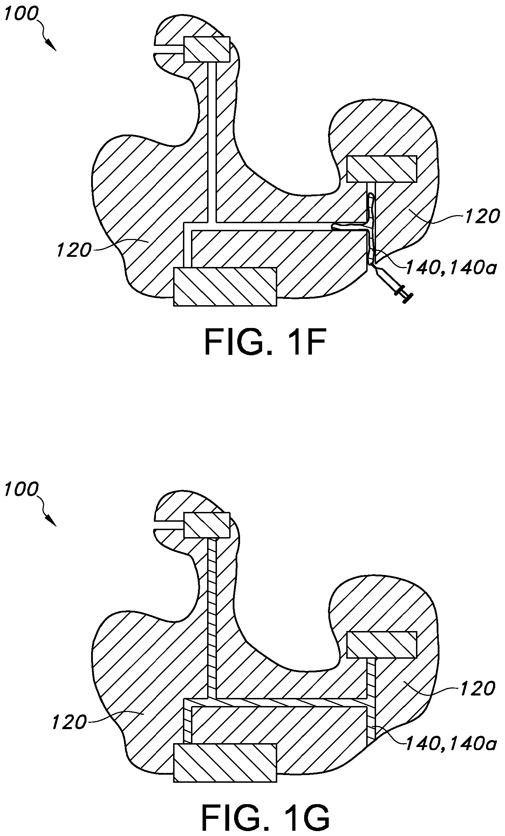

In figs. 1a-1i an example is schematically shown with functional components at the bottom of the 3D printed part (or 3D printed object 100) as well as embedded inside the 3D printed part. In this example we show a 3DP part with three electrical components. The process is not limited to this example of three electrical components and multiple electrical components could be added in the same way. In Fig. 1a a process step or stage is shown, wherein an electrical component 400 is first placed on the build platform and overprinted with a few layers (indicated with printed material 120). The printing of the part is started, leaving gaps where the tunnels (or channels) will be formed. Reference 2120 indicates printed material being electrically insulating. In a next stage, see Fig. 1b, a second electrical component is added. The second electrical component may be aligned such that the conductive pads are over the desired tunnels running upwards from conductive pads on the first electrical component. 3D printing may be continued, leaving gaps where the tunnels (or channels) will be formed (Fig. 1c). Yet, by way of example a third electrical component may be added (Fig. 1d). The third electrical component may be aligned such that the conductive pads are over the desired tunnels running upwards from conductive pads on the first and second electrical component. In a further stage, the 3D printed part may be completed (Fig. 1e). At this point, the filling stage may commence (Fig. 1f) and the conducting liquid is inserted into the tunnels, or channels, by (1) injection or (2) dipping the part into a liquid bath. At this stage each tunnel or channel has at least one entrance through which the liquid can be provided. The liquid could e.g. be silver ink or an ionic liquid like water or molten metal. This will complete the circuits. Further, the liquid may be cured, if possible, and/or the tunnels may be sealed (Fig. 1g). The functional components 400 may be different type of functional components, such as a light source, a control unit and a sensor, a power source, etc.. As shown, in this way interconnects are made.

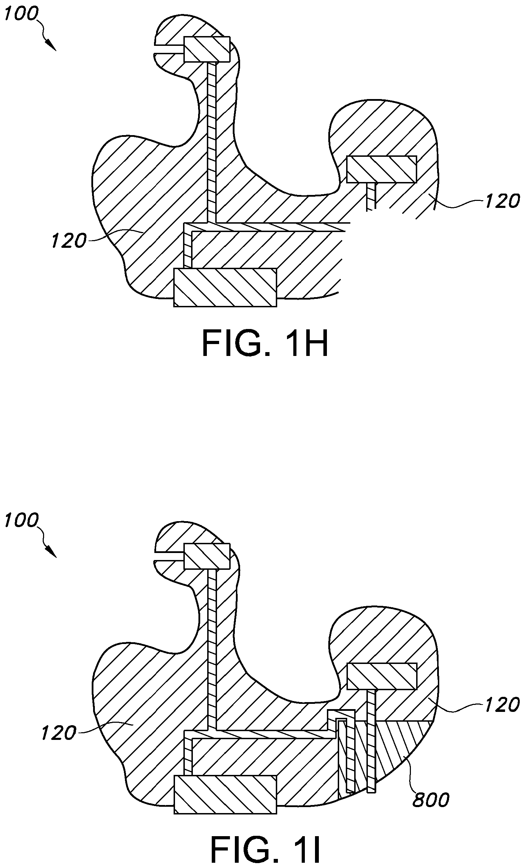

Optionally, an electrical connection may deliberately be broken or interrupted (Fig. 1h). One may reveal connecting tracks by the dissolution of selectively printed material (see Fig.1i). This may e.g. be achieved by printing two types of material "at the same time" (one resistant to dissolution and the other soluble), injecting the conductors (and hardening them), followed by dissolving the material around the conductors desired to use as external connection structures.

Further, optionally the circuit can be completed by dipping the circuit into water (water acts as switch). Hence, in a further embodiment a second electrically conductive pad necessary for electrical connection may be provided submerging the 3D object in an electrically conductive liquid, or a precursor of an electrically conductive coating or filling material. Hence, for instance one pad is provided by filling the channels, the other pad by embedding/plating the whole 3D printed object with a conductive material that touches the emerged parts of the components. Hence, in embodiments the liquid may be an electrically conductive liquid that is used to penetrate and fill the channel 200. After closing the channel 200, an (immobilized) electrically conductive pad is available.

The above drawings are very schematic. Double tracks, as is in general the case for electrical components, are not drawn for the sake of clarity.

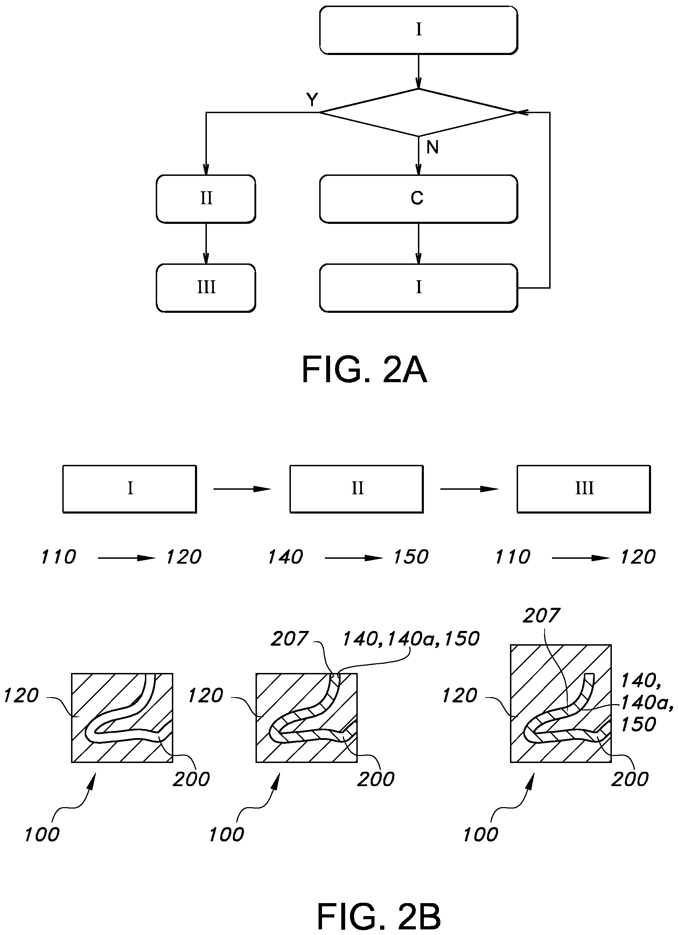

Fig 2a schematically depicts a general embodiment of the method as described herein. One may start with printing (I). When printing is finished or when a part is finished, one may decide whether the 3D printing is entirely ready (Y) or more printing has to be done (N), such as including a functional component (C). After adding a functional component, 3D printing may be commenced (I). This may be repeated until the 3D object is ready. Thereafter, the channels can be filled (II) with flowable, or liquid, material, and e.g. the flowable material may be cured and/or the channels may be sealed, etc. (III). As mentioned above, alternative embodiments are also possible, such as starting with one or more functional components, or an intermediate filling (optionally with an intermediate sealing and/or curing).

Fig. 2b very schematically shows some stages and aspects of an embodiment. The method comprises (i) a 3D printing stage, indicated with reference I, which may comprise 3D printing a 3D printable material 110 to provide the 3D printed object 100 of printed material 120, wherein the 3D printing stage further comprises forming during 3D printing a channel 200 in the 3D printed object 100 under construction, wherein the method further comprises (ii) a filling stage, indicated with reference II, comprising filling the channel 200 with a flowable, or liquid, material 140 comprising functional material 140a, and optionally curing the curable material 140 to provide the channel 200 with functional material 140a. Reference 150 indicates cured functional / flowable material. Hence, by way of example, here the flowable material 140 has been cured. Reference 150 may additionally or alternatively also indicate polymerized material, when the flowable material has been polymerized in the channel 200.

Optionally, the method may further comprise (iii) a finishing stage, indicated with reference III, subsequent to the filling stage II, wherein the finishing stage may comprise closing a channel opening 207, optionally but not necessarily by 3D printing. Note that the stages of filling the channels and curing the material may substantially be independent. Curing does not have to occur after each filling stage; it can occur after a certain number of filling stages or maybe just once at the end - depending on the printed and curable material properties and the curing mechanism. Alternatively, if the ambient temperature is high enough, no explicit curing action might be necessary, as over time the material will cure at this elevated temperature; i.e. automatically a curing stage may be included. Especially however, the printed material is subject to a temperature above ambient temperature. As indicated above, curing may also be done after e.g. at least part of a finishing stage, e.g. a finishing stage including closing the channel 200.

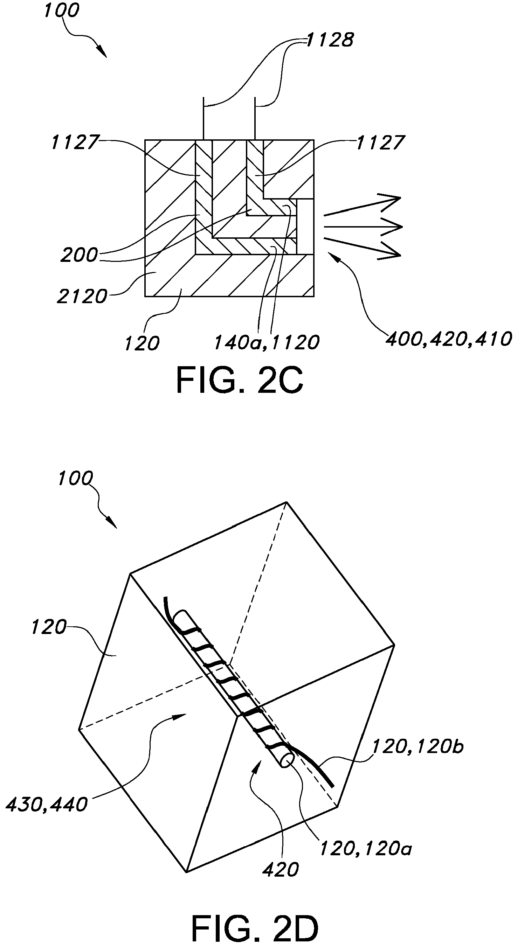

Fig. 2c schematically depicts a 3D printed object 100. As indicated above, in an embodiment the 3D printed object 100 comprises a first type of material or a functional material 140a, here electrically conductive material 1120, having electrically conductive properties and a second type of (printed) material 120 having electrically insulating properties. By way of example, this object 100 has further a light source 410 integrated, as an example of an electrical component 420, which is functionally connected with electrically conductive material 1120, here electrically conductive tracks 1127. Further connectors 1128 are functionally connected to these tracks 1127, for instance for a functional connection with a power source (not depicted). The electrical conductive tracks 1127 may thus comprise functional material 140a having electrically conductive properties.

Fig. 2d schematically depicts a 3D printed object 100 having two different channels 200, a first channel 120a including iron or ferrite material, and a second channel 200b, with printed material 120 (especially thus not electrically conductive) in between, including an electrically conductive material. The first channel 200a is arranged as core and the second channel 200b being arranged as coil. In this way, an inductor can be made. For instance, such structure can be used to make a solenoid or an electro magnet.

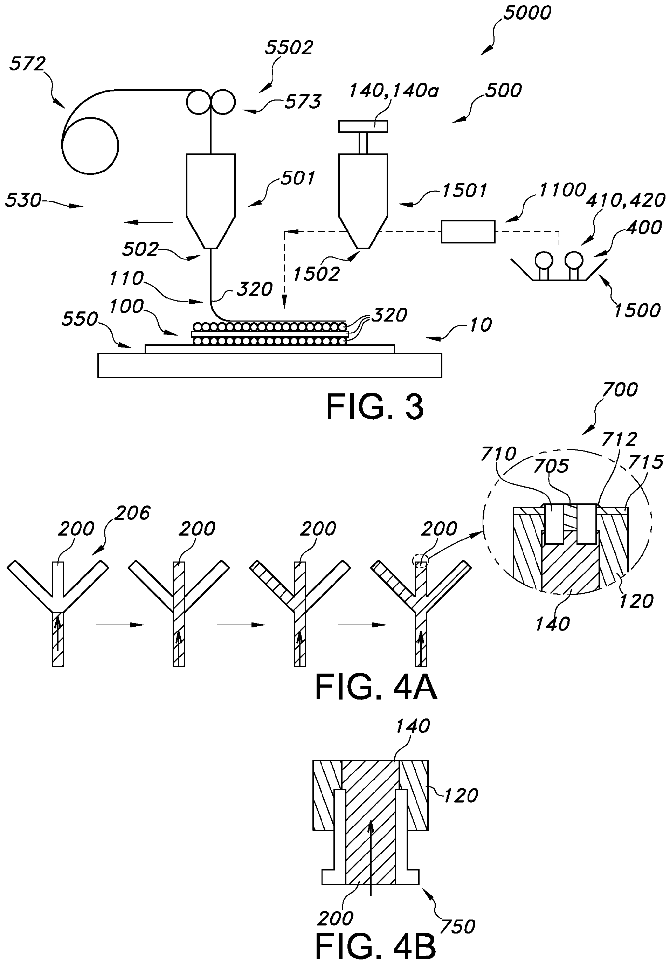

Fig. 3 schematically depicts a 3D printer apparatus 5000 for providing a 3D printed object 100, the 3D printer apparatus 5000 comprising a 3D printer 500 configured to provide printable material 110 to provide the 3D printed object 100. The 3D printer apparatus 5000 comprises a functional material providing device 5502 configured to provide flowable, or liquid, material 140, comprising a functional material 140a, to a channel (not depicted) of said 3D printed object 100. Further, the 3D printer apparatus 5000 comprises a transportation unit 1100 configured to transport a functional component 400 from a storage position 1500 to a 3D printed object 100 under construction for at least partial integration of said functional component 400 in said 3D printed object (100). Fig. 3 especially schematically depicts an embodiment of a 3D printer that might e.g. be used for the AM method as described herein. This Fig. 3 shows a 3D printer 500 (or apparatus 5000) comprising a printer head 501 comprising a first nozzle 502 for printing a 3D printable material 110 to a receiver item 550, the 3D printer 500 further comprising a second printer nozzle 1502 (for instance from another printer head 1501) for providing a flowable material 140 comprising a functional material 140a, and wherein the 3D printer 500 (or apparatus 5000) further comprises a transportation unit 1100 configured to transport a functional component 400 from a storage position 1500 to the 3D printed object 100 (under construction). The dashed arrows indicate by way of example the path a functional component 400, such as an electrical component 420, like a light source 410, may be transported from the storage position to the 3D printed object 100. The transportation unit can e.g. be used for picking and placing a functional component and/or by inserting a flexible circuit, or other functional component, using e.g. a roll-to-roll process. Reference 500 indicates a 3D printer. Reference 530 indicates the functional unit configured to 3D print, especially FDM 3D printing; this reference may also indicate the 3D printing stage unit. Here, only the printer head for providing 3D printed material, such as a FDM 3D printer head is schematically depicted. Reference 501 indicates the printer head. The 3D printer of the present invention may especially include a plurality of printer heads, though other embodiments are also possible. Reference 502 indicates a printer nozzle. The 3D printer of the present invention may especially include a plurality of printer nozzles, though other embodiments are also possible. Reference 320 indicates a filament of printable 3D printable material (such as indicated above). For the sake of clarity, not all features of the 3D printer have been depicted, only those that are of special relevance for the present invention. The 3D printer 500 is configured to generate a 3D item 10 by depositing a plurality of filaments 320 on a receiver item 550 wherein each filament 20 comprises 3D printable material, such as having a melting point Tₘ. The 3D printer 500 is configured to heat the filament material upstream of the printer nozzle 502. This may e.g. be done with a device comprising one or more of an extrusion and/or heating function. Such device is indicated with reference 573, and is arranged upstream from the printer nozzle 502 (i.e. in time before the filament material leaves the printer nozzle 502). Reference 572 indicates a spool with material, especially in the form of a wire. The 3D printer 500 transforms this in a filament or fiber 320. Arranging filament by filament and filament on filament, a 3D item 10 may be formed. The 3D printing technique used herein is however not limited to FDM (see also above).

This method of the invention may include injecting conducting / insulating materials into a 3D printed shape to connect electronic components and circuits. In embodiments, 3D printing is a layer by layer technology, which may create small ribs inside the channels. Whatever material used to fill those channels, this may especially reproduce the negative of these structures, proving that it was added in the liquid phase after the formation of the channels by ways of 3D printing.

The invention also provides a method to be able to design and create only the channels where interconnect is needed, which are later on provided with a conductive material and cured into a proper conductor. Due to the fact that the conductive material will follow the channels, a total 3D design freedom is created inside the body of a 3D printed part. A huge benefit is that the same interconnect material can be used to contact boards and components, which reduces the assembly cost. Another benefit is that only one cure step (in the case of e.g. a silver loaded polymer) is needed afterwards and that the interconnect channel can be made truly 3D. Also subdivisions of channels into multiple channels are possible. Specific materials possible for filling the channels may e.g. be selected from silver loaded polymers (isotropically conductive adhesive; silver ink), or low melting solders. Both may require a certain thermal budget of the polymer carrier and for this reason the low Tg materials may be less relevant. Hence, polymers used herein - for 3D printing - may especially have a Tg of 70 °C or larger, such as 100 °C or larger, such as larger than 120 °C. There are silver loaded polymers available, which can be cured at e.g. 80-90 °C and still provide a reasonable conductivity. The low melting temperature solders provide the best conductivity and might be a better (and cheaper) alternative method of filling the channels. The low melting solder may especially melt below about 120 °C.

An element of the invention is the creation of the channels in the body of the 3D printed part. This enables a digitally designed and 3D freeform interconnect, which can be applied afterwards by injection (molding).

Some examples were made, starting with designing a 3D product with containing the channels. In this case, the designed channels were 1.5 mm in diameter. The body is to be provided with a specially prepared LED engine/module with holes in the middle of a contact, running through the print. By design, these holes are exactly located above the channels, to enable a direct contact. After design, the body was printed with the 1.5 mm channels running through the body. The material used was PLA (poly lactic acid), but ABS (acrylonitrile butadiene styrene) may also be a good choice, as the Tg of PLA is around 60 °C and ABS has a Tg of about 105 °C, which may be beneficial to withstand thermal curing of the flowable material including functional material. Experiments were also executed with ABS. In a next step, the printed channels were filled with a flowable, or liquid, conductor material. This material is transferring the power from the socket to the LED board on the optical output side of the designed luminaire. Like stated before, this can be done with silver loaded polymer (requires a cure step) or with a low melting temperature solder. Both will be described below.

The silver loaded polymer is in this case an isotropically conductive adhesive which needs a cure at 125 °C for 5 minutes. The filling is performed by a pressure syringe which is pressed into the channel from the bottom of the product. Applying pressure onto the syringe results in filling of the channel. This is performed until the material pops up at the top side of the channel, after which the second channel is filled.

Filling the channels was also performed with Sn/Bi/Cu solder using a heated injection tool to insert the solder. The material flows really well into the channels and is a proper conductor after coagulation. One could even think of contacting an already provided LED board at the top side of the product. Subsequently, the board and the wires were assembled. On the top side of the product, a LED engine was placed and the contact to the filled channel was made by dispensing ICA (isotropically conductive adhesive) onto the contact. At the bottom, wires were located into the first 5 mm of the channel, making the contact to the power source. Then the silver loaded polymer in the channels was cured. In this step the entire product was put in a convection furnace for 2 hours at 80 °C to allow the silver loaded polymer to cure and become a proper conductor. The PLA body could not substantially withstand this temperature, but when the body is made out of ABS, which can also be 3D printed, the body is capable of withstanding this temperature. Also, an alternative curing method can be thought, such as variable frequency microwave curing, which is common for curing ICA balls in the IC industry. Advantage of this method is that the entire body is not heated, while the ICA itself is heated until the point of curing. The thermal load on the body is therefore reduced only to the area just outside the channel. After these steps, the product is finished. Measuring the Ohmic resistance of the channels resulted in 1.2 Ohm over a 10 cm channel of 1.5 mm in diameter.

It is also possible to design multiple channels in one product to enable a more complex interconnect structure (for instance for connecting multiple boards or embedded driver electronics). This may also increase the complexity of the fill process. Hence, in a further aspect the invention provides a bifurcation structure 206. The most effective way of filling the channels is from the side where they all come together. If filled from the top, the combined part of channel will be filled with air during the fill of the second channel. Air needs to be pressed out and that results in a lot of wasted material. The problem however in filling from the combined channel is that there may be a difference in fluidic resistance in the track during filling, resulting in one filled channel as the other channels (with higher fluidic resistivity) remain empty. This problem can be solved by using a restriction (e.g. reduced diameter or size of the channel) at the end of a channel, only allowing the air to escape. As the first channel is filled form the combined channel, the air escapes through the restriction of the subdivided channel. When the fill material is hitting the restriction, the pressure will increase as it cannot pass the restriction and the second subdivided channel will be filled. This will proceed, until all channels are filled and no more fill material will go into the channels. The restriction can even provide the contact to the LED engine/module or other electronics, when a metal tube is providing the restriction function. This allows an added electrical function to the restriction, see Fig. 4a (wherein the left drawing indicates a combined channel fill, the second drawing from left shows the filling of the channel with the lowest fluidic resistance, followed by the other two channels). Fig. 4a also shows an embodiment of a possible restriction unit, wherein the restriction unit is indicated with reference 700. Reference 710 indicates a tube with a restriction 705 allowing gas to escape. Reference 715 indicates e.g. a PCB, and reference 712 indicates solder for connecting the restriction unit 700 with the PCB.

Further, a connector for injection may be applied, for instance at the entrance side of the channel. It is advantageous for the filling step (whether it is solder or silver loaded polymer) to have a good, firm and sealed contact to the body and channel to avoid air leakage or material spill. As in most cases some form of mechanical and electrical connection is needed to the outside world, one can think of having a connector for the filling process, for the mechanical attachment to the luminaire/foot and/or for the electrical connection. In Fig. 4b an example of such a socket/connector is drawn. Reference 750 indicates a metal fitting, such as a bayonet like fitting. This fitting 750 can be arranged in or can be configured as part of a channel (opening).

The invention can e.g. be used for embedding electronics intimately inside a product. For instance, LEDs are intimately embedded in the luminaire shape; in this way one may not need to use conventional bulbs. This fits into the general LEDification trend. Enabled lamps will mostly be high end designer luminaires. The invention can e.g. also be used for protection of fragile devices inside products, taking them away from the outside, e.g. a humidity / gas sensor that is embedded deep inside a part but still has a tunnel connection to the outside to allow the material that is being sensed to reach the sensor. The invention can e.g. also be used for personalized electronics and wearables that require a special fit to the body. The invention can e.g. also be used for product data protection and tracking: embedding of special features or product information inside the device, which cannot be removed easily (and perhaps are completely invisible to the outside). The invention can e.g. also be used for PCB free systems that are safe to touch, complex systems with connectors/components out of a 2D plane, a morphologically balanced system with regard to thermal management, connector structures directly printed, etc.. Hence, with the invention the number of components, junctions, connections may be reduced, thereby simplifying assembly and improving look & feel.

It would also be possible to provide circuits inside metal 3DP parts. Generally, one may make 3DP parts with electronic circuits involve adding conducting tracks to nonconductive 3D printed parts. But, there are many 3DP methods that are used to make metal parts. Metal printing is one of the more mature 3D printing methods that is used not only to make prototypes but actual parts, e.g. in the aerospace industry. The approaches used so far do not provide a solution if we want to create circuits inside metallic 3D printed parts. In this situation, it is desirable to create non-conducting areas or tracks inside a mainly conducting part. The method we propose herein also lends itself to adding non-conducting materials inside a 3DP part after printing and can therefore be used to insulate conducting regions inside a metal 3DP part. This process is in general a mirror, or the inverse, of the previous process because in this case tunnels are placed where we want to form insulating areas. The liquid that is injected is non-conducting. The challenge in this case is to design the electrical circuit so that pads are correctly connected, and insulated from the metallic 3DP structure where necessary. Hence, in a further aspect the invention provides a method for the production of a 3D printed object, wherein the method comprises (i) a 3D printing stage, the 3D printing stage comprising 3D printing a 3D printable material to provide the 3D printed object, wherein the printable material comprises an electrically conductive material or a precursor of an electrically conductive material, wherein the 3D printing stage further comprises forming during 3D printing a channel in the 3D printed object under construction, wherein the method further comprises (ii) a filling stage comprising filling the channel with a flowable (or liquid) material, wherein the flowable material comprises a functional material or a precursor thereof, wherein the functional material has electrically insulating properties. In yet a further aspect, the invention also provides a 3D printed object comprising (i) a functional component at least partially incorporated in the 3D printed object, and (ii) a channel integrated in the 3D printed object, wherein the 3D printed object comprises electrically conductive material, wherein the channel comprises an immobilized functional material, wherein the functional material comprises an electrically insulating material, wherein the functional component comprises one or more of an electrical component, a solenoid, an antenna, a capacitive coupling structure, and an electro magnet, and wherein the functional component and the electrically conducting material functionally coupled. Especially here, term "channel" may also refer to layer or a plurality of layers. Further, such method may also include a disconnection stage wherein parts that are electrically conductive, but should not be in electrical contact with each other, are disconnected (e.g. by removing (part of) a layer).

## Claims

1. A method for the production of a 3D printed object (100), wherein the method comprises:
(i) a 3D printing stage, the 3D printing stage comprising 3D printing a 3D printable material (110) to provide the 3D printed object (100), wherein the 3D printing stage further comprises forming during 3D printing a tunnel (200) in the 3D printed object (100) under construction, and
(ii) after the 3D printed object has been completely printed, a filling stage comprising filling the tunnel (200) with a flowable material (140),
wherein the flowable material (140) comprises a functional material (140a),
wherein the functional material (140a):
- has a higher electrical conductivity than the surrounding 3D printed material, and/or
- has a higher thermal conductivity than the surrounding 3D printed material, and/or
- has light transmissive properties in an indicated wavelength range such that the functional material can transmit at least 10 % of the light at one or more wavelengths within the indicated wavelength range, and/or
- comprises a magnetic material, and
wherein the filling stage comprises immobilizing said functional material (140a).

2. The method according to claim 1, wherein the printing stage further comprises at least partially incorporating a functional component (400) in the 3D printed object (100) under construction, wherein the functional component (400) comprises one or more of an electrical component (420), a solenoid (430), an antenna, a capacitive coupling structure, and an electro magnet (440), and wherein the filling stage further comprises functionally connecting the functional component (400) with the functional material (140a) by filling said tunnel (200) with said flowable material (140).

3. The method according to claim 2, wherein the functional component (400) comprises a light source (410) and wherein said functional material (140a) comprises an electrically conductive material.

4. The method according to any one of the preceding claims 2-3 wherein the functional component (400) is completely incorporated in the 3D printed object (100).

5. The method according to any one of the preceding claims, wherein the functional material (140a) is immobilized by one or more of (a) closing said tunnel (200) and curing said functional material comprising flowable material (140).

6. The method according to any one of the preceding claims, wherein the flowable material (140) comprises a curable material, and wherein the method further comprises curing said flowable material (140) to provide cured functional material (150).

7. The method according to any one of the preceding claims, wherein the flowable material (140) has a viscosity equal to or larger than 2 mPa.s at 20 °C.

8. The method according to any one of the preceding claims, wherein the flowable material (140) comprises a metal particles comprising polymer.

9. The method according to any one of the preceding claims, wherein the flowable material (140) comprises a low melting solder melting at a temperature selected from the range of 50-400 °C.

10. The method according to any one of the preceding claims, wherein the filling stage comprises subjecting the 3D printed object (100) to subatmospheric pressure and subsequently filling the tunnel (200) with the flowable material (140).

11. The method according to any one of the preceding claims, wherein the tunnel (200) comprises a bifurcation structure (206).

12. A 3D printer apparatus (5000) for producing a 3D printed object (100) according to the method of claim 1, the 3D printer apparatus (5000) comprising:
(i) a 3D printer (500) configured to provide printable material (110) to completely print the 3D printed object (100),
(ii) a functional material providing device (5502) configured to provide flowable material (140), comprising a functional material (140a), to a tunnel (200) of said completely printed 3D printed object (100), and
(iii) a transportation unit (1100) configured to transport a functional component (400) from a storage position (1500) to a completely printed 3D printed object (100) for at least partial integration of said functional component (400) in said 3D printed object (100).

## Patentansprüche

1. Verfahren zur Herstellung eines 3D-Druck-Objekts (100), wobei das Verfahren Folgendes umfasst:
(i) eine 3D-Druck-Stufe, wobei die 3D-Druck-Stufe 3D-Druck eines 3D-druckfähigen Materials (110) umfasst, um das 3D-Druck-Objekt (100) bereitzustellen, wobei die 3D-Druck-Stufe weiter Formen eines Tunnels (200) in dem sich im Aufbau befindlichen 3D-Druck-Objekt (100) während des 3D-Drucks umfasst, und
(ii) nachdem das 3D-Druck-Objekt vollständig gedruckt ist, eine Füllstufe, die Füllen des Tunnels (200) mit einem fließfähigen Material (140) umfasst,
wobei das fließfähige Material (140) ein Funktionsmaterial (140a) umfasst,
wobei das Funktionsmaterial (140a):
- eine höhere elektrische Leitfähigkeit aufweist als das umgebene 3D-gedruckte Material, und/oder
- eine höhere Wärmeleitfähigkeit aufweist als das umgebene 3D-gedruckte Material, und/oder
- Lichtdurchlasseigenschaften in einem angegebenen Wellenlängenbereich aufweist, sodass das Funktionsmaterial mindestens 10 % des Lichts in einer oder mehreren Wellenlängen innerhalb des angegebenen Wellenlängenbereichs übertragen kann, und/oder
- ein magnetisches Material umfasst, und
wobei die Füllstufe Immobilisieren des Funktionsmaterials (140a) umfasst.

2. Verfahren nach Anspruch 1, wobei die Druckstufe weiter mindestens teilweises Einbringen einer Funktionskomponente (400) in das sich im Aufbau befindliche 3D-Druck-Objekt (100) umfasst, wobei die Funktionskomponente (400) eine oder mehrere elektrische Komponenten (420), eine Magnetspule (430), eine Antenne, eine kapazitive Kupplungsstruktur und einen Elektromagneten (440) umfasst, und wobei die Füllstufe weiter funktionelles Verbinden der Funktionskomponente (400) mit dem Funktionsmaterial (140a) durch Füllen des Tunnels (200) mit dem fließfähigen Material (140) umfasst.

3. Verfahren nach Anspruch 2, wobei die Funktionskomponente (400) eine Lichtquelle (410) umfasst, und wobei das Funktionsmaterial (140a) ein elektrisch leitendes Material umfasst.

4. Verfahren nach einem der vorstehenden Ansprüche 2-3, wobei die Funktionskomponente (400) vollständig in das 3D-Druck-Objekt (100) eingebracht ist.

5. Verfahren nach einem der vorstehenden Ansprüche, wobei das Funktionsmaterial (140a) durch Eines oder Mehreres von (a) Schließen des Tunnels (200) und Aushärten des Funktionsmaterials, das fließfähige Material (140) umfasst, immobilisiert wird.

6. Verfahren nach einem der vorstehenden Ansprüche, wobei das fließfähige Material (140) ein aushärtbares Material umfasst, und wobei das Verfahren weiter Aushärten des fließfähigen Materials (140) umfasst, um ausgehärtetes Funktionsmaterial (150) bereitzustellen.

7. Verfahren nach einem der vorstehenden Ansprüche, wobei das fließfähige Material (140) eine Viskosität von gleich oder größer als 2 mPa.s bei 20 °C aufweist.

8. Verfahren nach einem der vorstehenden Ansprüche, wobei das fließfähige Material (140) ein Metallpartikel enthaltendes Polymer umfasst.

9. Verfahren nach einem der vorstehenden Ansprüche, wobei das fließfähige Material (140) ein niedrigschmelzendes Lot umfasst, das bei einer Temperatur, die aus dem Bereich von 50-400 °C ausgewählt ist, schmilzt.

10. Verfahren nach einem der vorstehenden Ansprüche, wobei die Füllstufe Unterziehen des 3D-Druck-Objekts (100) unter unteratmosphärischem Druck und darauffolgendes Füllen des Tunnels (200) mit dem fließfähigen Material (140) umfasst.

11. Verfahren nach einem der vorstehenden Ansprüche, wobei der Tunnel (200) eine Gabelungsstruktur (206) umfasst.

12. 3D-Druckereinrichtung (5000) zum Herstellen eines 3D-Druck-Objekts (100) gemäß dem Verfahren nach Anspruch 1, wobei die 3D-Druckereinrichtung (5000) Folgendes umfasst:
(i) einen 3D-Drucker (500), der ausgelegt ist, um druckbares Material (110) bereitzustellen, um das 3D-Druck-Objekt (100) vollständig zu drucken,
(ii) eine Funktionsmaterialbereitstellungsvorrichtung (5502), die ausgelegt ist, um einem Tunnel (200) des vollständig gedruckten 3D-Druck-Objekts (100) fließfähiges Material (140), das ein Funktionsmaterial (140a) umfasst, bereitzustellen, und
(iii) eine Beförderungseinheit (1100), die ausgelegt ist, um eine Funktionskomponente (400) von einer Lagerposition (1500) zu einem vollständig gedruckten 3D-Druck-Objekt (100) zur mindestens teilweisen Integration der Funktionskomponente (400) in das 3D-Druck-Objekt (100) zu befördern.

## Revendications

1. Procédé pour la production d'un objet imprimé en 3D (100), dans lequel le procédé comprend :
(i) une étape d'impression en 3D, l'étape d'impression en 3D comprenant une impression en 3D d'un matériau pouvant être imprimé en 3D (110) pour fournir l'objet imprimé en 3D (100), dans lequel l'étape d'impression en 3D comprend en outre la formation, pendant l'impression en 3D, d'un tunnel (200) dans l'objet imprimé en 3D (100) en cours de construction, et
(ii) après que l'objet imprimé en 3D a été complètement imprimé, une étape de remplissage comprenant le remplissage du tunnel (200) avec un matériau liquide (140),
dans lequel le matériau liquide (140) comprend un matériau fonctionnel (140a),
dans lequel le matériau fonctionnel (140a) :
- présente une conductivité électrique plus élevée que celle du matériau imprimé en 3D environnant et/ou
- présente une conductivité thermique plus élevée que celle du matériau imprimé en 3D environnant et/ou
- présente des propriétés de transmission de lumière dans une plage de longueur d'onde indiquée de telle sorte que le matériau fonctionnel puisse transmettre au moins 10 % de la lumière à une ou plusieurs longueurs d'onde dans la plage de longueur d'onde indiquée et/ou
- comprend un matériau magnétique, et
dans lequel l'étape de remplissage comprend l'immobilisation dudit matériau fonctionnel (140a).

2. Procédé selon la revendication 1, dans lequel l'étape d'impression comprend en outre l'incorporation au moins partiellement d'un composant fonctionnel (400) dans l'objet imprimé en 3D (100) en cours de construction, dans lequel le composant fonctionnel (400) comprend un ou plusieurs d'un composant électrique (420), d'un solénoïde (430), d'une antenne, d'une structure de couplage capacitif et d'un électroaimant (440) et dans lequel l'étape de remplissage comprend en outre une fonctionnalité reliant le composant fonctionnel (400) au matériau fonctionnel (140a) par remplissage dudit tunnel (200) avec ledit matériau liquide (140).

3. Procédé selon la revendication 2, dans lequel le composant fonctionnel (400) comprend une source de lumière (410) et dans lequel ledit matériau fonctionnel (140a) comprend un matériau électroconducteur.

4. Procédé selon l'une quelconque des précédentes revendications 2-3, dans lequel le composant fonctionnel (400) est complètement incorporé dans l'objet imprimé en 3D (100).

5. Procédé selon l'une quelconque des revendications précédentes, dans lequel le matériau fonctionnel (140a) est immobilisé par un ou plusieurs (a) de la fermeture dudit tunnel (200) et du durcissement dudit matériau fonctionnel comprenant un matériau liquide (140).

6. Procédé selon l'une quelconque des revendications précédentes, dans lequel le matériau liquide (140) comprend un matériau durcissable et dans lequel le procédé comprend en outre le durcissement dudit matériau liquide (140) pour fournir un matériau fonctionnel durci (150).

7. Procédé selon l'une quelconque des revendications précédentes, dans lequel le matériau liquide (140) présente une viscosité égale ou supérieure à 2 mPa.s à 20 °C.

8. Procédé selon l'une quelconque des revendications précédentes, dans lequel le matériau liquide (140) comprend des particules métalliques comprenant un polymère.

9. Procédé selon l'une quelconque des revendications précédentes, dans lequel le matériau liquide (140) comprend une brasure à bas point de fusion fondant à une température sélectionnée dans la plage de 50-400 °C.

10. Procédé selon l'une quelconque des revendications précédentes, dans lequel l'étape de remplissage comprend la soumission de l'objet imprimé en 3D (100) à une pression subatmosphérique et, par la suite, le remplissage du tunnel (200) avec le matériau liquide (140).

11. Procédé selon l'une quelconque des revendications précédentes, dans lequel le tunnel (200) comprend une structure de bifurcation (206).

12. Appareil d'impression en 3D (5000) pour produire un objet imprimé en 3D (100) selon le procédé de la revendication 1, l'appareil d'impression en 3D (5000 comprenant :
(i) une imprimante 3D (500) configurée pour fournir un matériau imprimable (110) pour imprimer complètement l'objet imprimé en 3D (100),
(ii) un dispositif de fourniture de matériau fonctionnel (5502) configuré pour fournir un matériau liquide (140), comprenant un matériau fonctionnel (140a), à un tunnel (200) dudit objet imprimé en 3D imprimé complètement (100), et
(iii) une unité de transport (1100) configurée pour transporter un composant fonctionnel (400) depuis une position de stockage (1500) jusqu'à un objet imprimé en 3D imprimé complètement (100) pour une intégration au moins partielle dudit composant fonctionnel (400) dans ledit objet imprimé en 3D (100).
